# FASCICULE DE BREVET EUROPEEN

(11) **EP 2 013 902 B1**
(45) Date de publication et mention de la délivrance du brevet: **03.01.2018**
(21) Numéro de dépôt: 07728767.0
(22) Date de dépôt: 03.05.2007
(51) Int. Cl.: H01L 21/336, H01L 29/786, C23C 16/04, C23C 16/18, H01L 21/3205, H01L 29/423

(54) **PROCEDE DE REALISATION D'UNE GRILLE DE TRANSISTOR COMPRENANT UNE DECOMPOSITION D'UN MATERIAU PRECURSEUR EN AU MOINS UN MATERIAU METALLIQUE, A L'AIDE D'AU MOINS UN FAISCEAU D'ELECTRONS**
VERFAHREN ZUR HERSTELLUNG EINES TRANSISTOR-GATE MIT ZERLEGUNG EINES PRECURSOR-MATERIALS IN MINDESTENS EIN METALLMATERIAL MITTELS MINDESTENS EINES ELEKTRONENSTRAHLS
METHOD OF PRODUCING A TRANSISTOR GATE COMPRISING DECOMPOSITION OF A PRECURSOR MATERIAL INTO AT LEAST ONE METALLIC MATERIAL, BY MEANS OF AT LEAST ONE ELECTRON BEAM

(30) Priorité: 04.05.2006 FR 0651616
(43) Date de publication de la demande: 14.01.2009
(73) Titulaire: Commissariat à l'Énergie Atomique et aux Énergies Alternatives, 75015 Paris (FR)
(72) Inventeur: ERNST, Thomas, 38210 Morette (FR); LANDIS, Stéfan, 38500 Voiron (FR)
(74) Mandataire: Ilgart, Jean-Christophe
(86) Numéro de dépôt international: PCT/EP2007/054314
(87) Numéro de publication internationale: WO 2007/128780

(56) Documents cités:
- US-A1- 2004 063 286
- US-A1- 2005 037 603
- US-A1- 2005 227 181
- US-A1- 2006 011 912
- US-A1- 2006 049 429
- US-B1- 6 413 802
- DICKS M. H., BROXTON G. M. ET AL.: "A test chip to characterise P-MOS transistors produced using a novel organometallic material" IEEE PROCEEDINGS 2004 -INTERNATIONAL CONFERENCE ON MICROELECTRONIC TEST STRUCTURES, vol. 17, mars 2004 (2004-03), pages 183-187, XP002399038
- KRATSCHNER E., ISAACSON M.: "Nanostructure fabrication in metals, insulators, and semiconductors using self-developping metal inorganic resist" JOURNAL OF VACUUM SCIENCE AND TECHNOLOGY - B, vol. 4, no. 1, janvier 1986 (1986-01), pages 361-364, XP002399039
- PATENT ABSTRACTS OF JAPAN vol. 012, no. 148 (C-493), 7 mai 1988 (1988-05-07) & JP 62 263973 A (KAZUMICHI OMURA), 16 novembre 1987 (1987-11-16)

## Description

### DOMAINE TECHNIQUE

La présente invention se rapporte au domaine des circuits intégrés, et plus particulièrement à celui des transistors, et a pour but de présenter un procédé microélectronique amélioré de réalisation de grilles de transistors, comprenant une décomposition d'un matériau précurseur en au moins un matériau métallique destiné à former un matériau de grille, à l'aide d'au moins un faisceau d'électrons. L'invention s'applique en particulier à la réalisation de structures multi-grilles, ou de grilles dites « partiellement enrobantes » ou « enrobantes » ou GAA (GAA pour « Gate All Around » ou « grille tout autour »).

### ART ANTÉRIEUR

Une structure de transistor est généralement formée sur un substrat, par exemple de type SOI (SOI pour « silicon on insulator » ou « silicium sur isolant »), d'une région de source et d'une région de drain, par exemple sous forme respectivement d'une première zones semi-conductrice et d'une deuxième zones semi-conductrice, reliées entre elles par une structure semi-conductrice destinée à jouer le rôle d'un canal ou de plusieurs canaux dans le(s)quel(s) un courant est destiné à circuler, et qui peut avoir une forme d'un bloc ou d'un barreau, ou éventuellement de plusieurs barreaux semi-conducteurs disjoints. Ce barreau ou ces barreaux semi-conducteurs sont recouverts d'une grille permettant de contrôler l'intensité du courant transitant dans le canal ou éventuellement dans les canaux.

Dans un dispositif classique de transistor MOS (MOS pour « Metal Oxide Semiconductor »), comportant une structure de grille conventionnelle, le matériau de grille est disposé sur le canal, de manière à ne recouvrir qu'une seule face du bloc semi-conducteur dans lequel ce canal est formé. Pour améliorer les propriétés électriques des transistors et en particulier le contrôle des fuites à l'état bloqué pour des longueurs de canaux faibles, par exemple inférieures à 50 nanomètres, des structures de grilles plus complexes sont apparues.

Il existe par exemple un type de grille que l'on appellera « partiellement-enrobante ».

Par grille « partiellement-enrobante », on entendra tout au long de la présente description que la grille comporte au moins deux régions situées dans des plans différents.

Une grille « semi-enrobante » peut être par exemple une grille dans lequel le matériau de grille repose sur le canal et est également formée sur chacune des faces latérales de ce dernier.

Le document US 6 413 802 présente par exemple un transistor de type dit « FinFet », doté d'un tel type de grille. Ce transistor comprend un canal sous forme d'un barreau parallélépipédique semi-conducteur reliant deux blocs semi-conducteurs de source et de drain. La grille est formée sur le dessus du barreau parallélépipédique semi-conducteur et également sur les flancs de ce dernier, de manière à obtenir une zone de recouvrement de la grille sur le canal plus importante par rapport à un transistor MOS classique et ainsi un contrôle amélioré de la conduction de ce dernier. Un autre type de dispositif de transistor à grille partiellement enrobante, est présenté dans le document : « A fully depleted lean-channel transistor (DELTA) - A novel Vertical Ultrathin SOI MOSFET, Hisamoto et al., IEEE Electron device letters, vol. 11, n°1 january 1990 *».*

Un dispositif à grille partiellement enrobante, comportant une structure multi-canaux formée de plusieurs barreaux parallélépipédiques parallèles et juxtaposés sur un substrat, les barreaux reliant une région semi-conductrice de source et une région semi-conductrice de drain, et étant séparés entre eux par une distance établie par lithographie, est présenté dans le document : « Nanoscale CMOS Spacer FinFET for the Terabit Era », Choi et al., IEEE, 2002*.*

Il existe également des grilles de transistor dites « enrobantes » ou GAA (GAA pour « gate all around » ou grille tout autour). On entendra tout au long de la présente description par « grilles enrobantes », des grilles pour lesquelles le matériau de grille est formé tout autour d'une portion du bloc semi-conducteur de canal, et réalise par exemple une bague ou un contour fermé autour de ce bloc. Le document US 2004/0063286 A1 présente par exemple un transistor comprenant un tel type de grille. Ce transistor est doté d'une structure multicanaux formée de barreaux semi-conducteurs parallélépipédiques superposés et réalisée de sorte qu'une ouverture existe entre chaque barreaux. Les barreaux semi-conducteurs parallélépipédiques sont également entourés ou encerclés sur une partie de leur longueur, d'un matériau de grille comblant les ouvertures situées entre les barreaux.

La réalisation de grilles « partiellement enrobantes » ou « enrobantes », sur des structures semi-conductrices de canal telles que précédemment décrites est difficile à mettre en oeuvre. Cette réalisation fait appel soit à des procédés microélectroniques de type Damascène, soit à des procédés comprenant des étapes de dépôt d'un matériau de grille, puis de retrait localisé de ce matériau par gravure.

Le problème de retrait du matériau de grille peut également apparaître, lorsqu'il s'agit de retirer ce matériau sur les flancs d'un barreau destiné à jouer le rôle de canal, par exemple pour un dispositif de type finfet tel que décrit dans le document US 6 413 802.

Les procédés de type Damascène sont souvent complexes ou/et nécessitent de nombreuses étapes technologiques.

Les procédés de type Damascène nécessitent notamment une étape de retrait du matériau de grille, par polissage ou gravure. Les procédés de type Damascène ont également généralement pour inconvénient de comporter une étape de formation de zones d'isolant de grille, en contact avec les régions de source et de drain.

En ce qui concerne les procédés mettant en oeuvre un dépôt puis une gravure du matériau de grille, c'est généralement cette étape de gravure qui pose problème, d'autant plus lorsque la structure de canal sur laquelle on souhaite former la grille est non planaire. Avec les procédés de gravure isotropes, en particulier chimiques, il est difficile d'obtenir des côtes ou dimensions critiques de grilles uniformes. Les procédés de gravure anisotropes existants, par exemple à l'aide de plasmas, ont quant à eux pour inconvénient de laisser des résidus indésirables de matériau de grille, lorsque la formation de la grille nécessite une gravure sous la structure de canal. La gravure plasma pose problème par exemple lorsque la structure de canal est formée de barreaux semi-conducteurs alignés verticalement, ou d'un barreau suspendu, et qu'il s'agit de retirer le matériau de grille sous ces barreaux.

Le document XP002399038 décrit la formation d'une grille de transistor par décomposition d'un matériau précurseur organométallique en un matériau métallique sous l'effet d'un faisceau de rayons lumineux (rayons UV).

Le document XP002399039 concerne l'utilisation d'un précurseur à base d'un composé de nature minérale (AlF3) pour la réalisation de motifs en Al, et ce par exposition du matériau précurseur à un faisceau d'électrons. Il se pose le problème de trouver un nouveau procédé microélectronique de réalisation de grilles de transistors, notamment pour former des grilles de type « partiellement enrobantes » ou « enrobantes », qui ne comporte pas les inconvénients évoqués ci-dessus.

### EXPOSÉ DE L'INVENTION

La présente invention a pour but de présenter un procédé microélectronique optimisé de réalisation de transistors, et en particulier un procédé amélioré de réalisation de grilles de transistors à l'aide d'un matériau précurseur qui peut être un organométallique, ou un composé de nature minérale comportant au moins un élément métallique, ou un composé sous forme de vapeur et comportant au moins un élément métallique, ledit matériau précurseur étant apte à être décomposé à l'aide d'au moins un faisceau d'électrons en au moins un matériau métallique destiné à former un matériau de grille.

L'invention prévoit un procédé de réalisation d'un dispositif microélectronique à un ou plusieurs transistors, comprenant la réalisation d'au moins une grille de transistor(s) sur une structure semi-conductrice comportant un ou plusieurs barreaux aptes à jouer le rôle d'un ou plusieurs canaux de transistors, la réalisation de ladite grille comprenant: la décomposition d'un matériau précurseur en au moins un matériau métallique destiné à former un matériau de grille, à l'aide d'au moins un faisceau d'électrons. Un tel procédé permet notamment de former des grilles ayant une côte ou dimension critique uniforme ou sensiblement uniforme. Un tel procédé permet également de faciliter la réalisation de grilles de formes complexes, et nécessitant par exemple le retrait d'un matériau sous la structure semi-conductrice ou dans des zones à proximité de ladite structure semi-conductrice difficiles à atteindre par gravure anisotrope.

Un tel procédé peut permettre de s'affranchir d'une étape de retrait de matériau de grille, par exemple par polissage ou gravure.

La mise en oeuvre du procédé à l'aide d'un faisceau d'électrons, peut permettre de former une grille localisée sur une portion du barreau ou des barreaux.

Selon un premier aspect, l'invention prévoit un procédé de réalisation d'un dispositif microélectronique à un ou plusieurs transistors, comprenant la réalisation d'au moins une grille de transistor(s) sur une structure semi-conductrice comportant un ou plusieurs barreaux aptes à jouer le rôle d'un ou plusieurs canaux de transistors, la réalisation de ladite grille comprenant les étapes de :
a) dépôt sur au moins une partie de ladite structure semi-conductrice, d'au moins une couche à base d'un matériau précurseur organométallique,
b) exposition d'une ou plusieurs zones de la couche à base du matériau précurseur organométallique à au moins un faisceau d'électrons,
c) réduction du matériau précurseur organométallique de manière à former une ou plusieurs zones métalliques sur ladite structure au niveau desdites zones exposées au(x) faisceau(x).

Ledit matériau organométallique utilisé peut être un matériau photosensible ou/et sensible à l'effet d'un faisceau ou d'une émission ou d'une projection d'électrons. Selon une mise en oeuvre particulière, le matériau organométallique peut être à base du composé suivant ou de la molécule suivante : 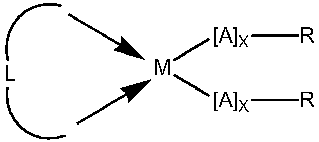 avec :
- M un métal qui peut être choisi parmi les métaux suivants : platine, cuivre, rhodium, tungstène, iridium, argent, or, tantale, palladium ;
- A un atome ou une molécule qui peut être choisie parmi la liste suivante : oxygène, soufre, groupement amine, groupement amide, groupement ester ;
- X un nombre choisi entre 0 et 1 ;
- L un ligand ;
- R un groupement fluoro-organique, les zones métalliques formées à l'étape c) étant à base du métal M.

Selon un deuxième aspect, l'invention prévoit un procédé de réalisation d'un dispositif microélectronique à un ou plusieurs transistors, comprenant la réalisation d'au moins une grille de transistor(s) sur une structure semi-conductrice comportant un ou plusieurs barreaux aptes à jouer le rôle d'un ou plusieurs canaux de transistors, la réalisation de ladite grille comprenant les étapes de :
a) dépôt sur au moins une partie de ladite structure semi-conductrice, d'au moins une couche de matériau précurseur à base d'un composé de nature minérale comportant au moins un élément métallique et apte à être décomposé en au moins un matériau métallique sous l'effet d'un faisceau d'électrons,
b) exposition d'une ou plusieurs zones de la couche de matériau précurseur, à au moins un faisceau d'électrons, de manière à former sur la structure semi-conductrice, une ou plusieurs zones métalliques à base dudit matériau au niveau desdites zones exposées audit faisceau.

Selon une possibilité, ledit composé peut être un composé fluoré. Ledit composé peut être éventuellement choisi parmi l'un des composés suivants : BaF₂, SrF₂, MgF₂, LaF₃, FeF₂, CrF₂, AlF₃.

Le procédé suivant l'invention peut comprendre en outre, après exposition audit faisceau d'électrons :
- le retrait de zones non-exposées de la couche de matériau précurseur.

Selon une possibilité de mise en oeuvre du procédé pour laquelle ladite structure semi-conductrice repose sur un substrat et comporte au moins une cavité, ou au moins une ouverture, ou au moins un espace entre au moins deux desdits barreaux semi-conducteurs ou/et entre au moins un barreau semi-conducteur et le substrat, ledit dépôt de matériau précurseur peut être réalisé de manière à combler au moins une zone de ladite cavité ou dudit espace ou de ladite ouverture, à l'aide dudit matériau précurseur. Le procédé peut comprendre en outre : le retrait au moins partiel du matériau précurseur dans ladite zone comblée.

Selon un troisième aspect, l'invention prévoit un procédé de réalisation d'un dispositif microélectronique à un ou plusieurs transistors, comprenant la réalisation d'au moins une grille de transistor(s) sur une structure semi-conductrice comportant un ou plusieurs barreaux aptes à jouer le rôle d'un ou plusieurs canaux de transistors, la réalisation de ladite grille comprenant les étapes de :
a) placement de la structure semi-conductrice dans une vapeur d'un matériau précurseur apte à être décomposé en au moins un matériau métallique sous l'effet d'un faisceau d'électrons,
b) exposition localisée d'une ou plusieurs régions de ladite structure semi-conductrice à au moins un faisceau d'électrons, de manière à former une ou plusieurs zones métalliques à base dudit matériau métallique sur lesdites régions de ladite structure semi-conductrice exposées.

Selon une possibilité de mise en oeuvre du procédé, ladite structure semi-conductrice peut comporter un barreau semi-conducteur ou plusieurs barreaux semi-conducteurs distincts, reposant sur un substrat.

Selon une possibilité de mise en oeuvre du procédé qui peut être combinée avec la précédente, ladite structure semi-conductrice peut comprendre au moins un premier bloc semi-conducteur et au moins un deuxième bloc semi-conducteur reposant sur un substrat, un ou plusieurs barreaux semi-conducteurs reliant le premier bloc et le deuxième bloc, lesdits barreaux semi-conducteurs étant suspendus au-dessus du substrat et/ou n'étant pas en contact avec le substrat.

Selon une possibilité de mise en oeuvre du procédé qui peut être combinée avec les précédentes, ladite structure semi-conductrice peut comprendre au moins deux barreaux alignés dans une direction réalisant un angle non nul avec le plan principal du substrat, et disjoints.

Selon une possibilité de mise en oeuvre du procédé qui peut être combinée avec les précédentes ladite structure semi-conductrice peut comprendre au moins deux barreaux, alignés dans une direction parallèle avec un plan principal du substrat, et disjoints.

L'invention peut ainsi s'appliquer en particulier à la formation de grilles « partiellement enrobantes ». Ainsi, selon une possibilité, au moins une desdites zones métalliques formées peut comporter au moins deux régions situées dans des plans distincts, lesdites régions réalisant par exemple un angle non-nul sur au moins un desdits barreaux semi-conducteurs.

L'invention peut ainsi s'appliquer en particulier à la formation de grilles « enrobantes » sur des structures semi-conductrices complexes destinées à jouer le rôle d'un canal de transistor, ou d'un canal de transistor à plusieurs branches, ou de plusieurs canaux de transistors différents. Ainsi, selon une autre possibilité, au moins une desdites zones métalliques réalisées peut former un contour fermé ou une bague autour d'au moins un desdits barreaux semi-conducteurs.

Le procédé peut également comprendre après formation de ladite structure et préalablement à l'étape a), le dépôt d'au moins une couche de diélectrique de grille.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A à 1F, illustrent, selon une vue en perspective, les étapes d'un procédé de réalisation d'un dispositif microélectronique selon l'invention,
- la figure 2 illustre, selon une vue en coupe, une grille formée à l'aide d'un procédé suivant l'invention, sur une structure comportant des barreaux semi-conducteurs suspendus,
- la figure 3 illustre un exemple de molécule d'un matériau organométallique utilisé pour la réalisation d'une grille, lors d'un procédé suivant l'invention,
- les figures 4A à 4C, illustrent, selon une vue en perspective, la réalisation d'une grille sur une structure semi-conductrice comportant une ouverture à l'aide d'un procédé suivant l'invention,
- les figures 5A à 5B, illustrent, selon une vue en perspective, la réalisation d'une grille sur une structure dotée de barreaux semi-conducteurs juxtaposés à l'aide d'un procédé suivant l'invention,
- les figures 6A à 6D, illustrent, selon une vue en perspective, la réalisation d'une grille sur une structure dotée de barreaux semi-conducteurs séparés entre eux par une cavité, à l'aide d'un procédé suivant l'invention,
- les figures 7A à 7B, illustrent, selon une vue en perspective, les étapes d'une variante de procédé de réalisation d'un dispositif microélectronique selon l'invention,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

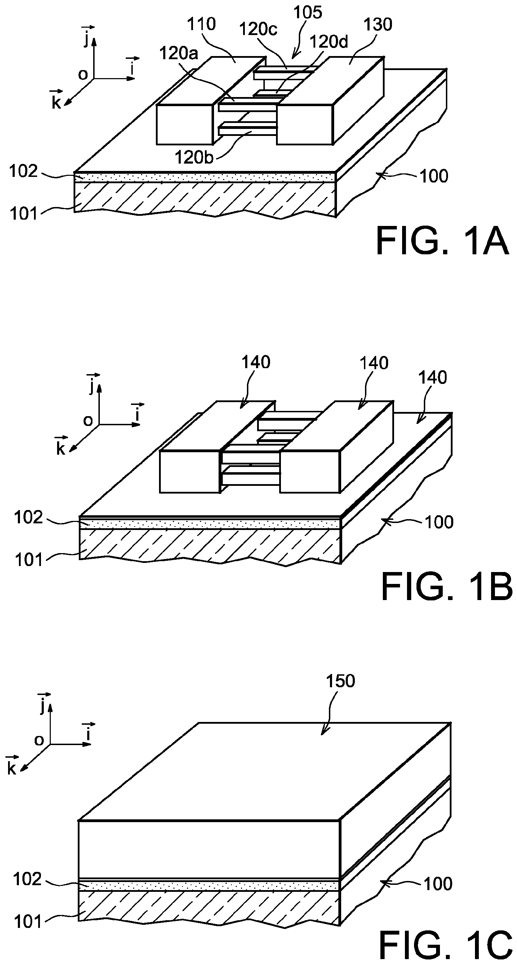

Un exemple de procédé microélectronique, suivant l'invention, va à présent être donné en liaison avec les figures 1A à 1F.

Le procédé est réalisé à partir d'au moins une structure semi-conductrice 105 destinée à former une structure de canal, ou de canal à plusieurs branches, ou une structure multi-canaux. Dans cet exemple, la structure 105 semi-conductrice relie au moins un premier bloc semi-conducteur 110 dans lequel au moins une région de source est destinée à être réalisée, et au moins un deuxième bloc semi-conducteur dans lequel au moins une région de drain 130 est destinée à être réalisée. Le premier bloc 110 et le deuxième bloc 130 reposent sur un substrat 100, qui peut être de type semi-conducteur sur isolant, par exemple de type SOI (SOI pour « Silicon On Insulator » ou « silicium sur isolant ») ou de type SiGeOI (SiGeOI pour « SiGe On Insulator » ou « SiGe sur isolant »). Le substrat peut être doté par exemple d'une première couche 101 de support mécanique, qui peut être à base de quartz ou à base d'un matériau semi-conducteur, par exemple à base de silicium, ainsi que d'une couche isolante 102 ou d'oxyde enterré (« burried oxide » selon la terminologie anglo-saxonne) par exemple à base de SiO₂, reposant sur la première couche 101, la couche isolante 102 servant de support au premier bloc 110 et au deuxième bloc 130. Le premier bloc 110 et le deuxième bloc 130 comprennent chacun une couche semi-conductrice ou plusieurs couches semi-conductrices superposées, dont au moins une couche semi-conductrice (non référencée) en contact avec la couche isolante 102. Ladite structure semi-conductrice 105 peut être sous forme de plusieurs éléments ou tiges ou fils ou barreaux semi-conducteurs disjoints, par exemple, comme le montre la figure 1A représentant une vue en perspective de la structure semi-conductrice, de quatre barreaux semi-conducteurs 120a, 120b, 120c, 120d. Dans un cas où les blocs 110 et 130 sont destinés à former respectivement, plusieurs régions de drains de transistors superposées et plusieurs régions de sources de transistors superposées, les barreaux 120a, 120b, 120c, 120d, peuvent être destinés à former plusieurs canaux de transistors, la structure semi-conductrice est alors dite « multi-canaux ». Les barreaux 120a, 120b, 120c, 120d, relient dans le sens de leur longueur (la longueur des fils 120a, 120b, 120c, 120d, étant définie sur la figure 1A dans une direction parallèle au vecteur *̅i̅*̅ d'un repère orthogonal [O;*̅i̅*̅;*̅j̅*̅;*̅k̅*̅]), une première face appartenant au premier bloc 110, et une deuxième face appartenant au second bloc 130, située en regard de ladite première face du premier bloc 110.

La longueur des barreaux 120a, 120b, 120c, 120d, peut être comprise par exemple entre 50 nanomètres et 1 micromètre, ou peut être voisine ou inférieure par exemple à la dimension critique de la grille destinée à être formée, ou peut être par exemple comprise entre 40 nanomètres et 300 nanomètres. Les barreaux 120a, 120b, 120c, 120d, peuvent avoir une épaisseur (définie dans une direction parallèle au vecteur *̅j̅*̅ du repère orthogonal [O;*̅i̅*̅;*̅j̅*̅;*̅k̅*̅]) comprise par exemple entre 3 et 200 nanomètres, ou avantageusement comprise entre 3 et 20 nanomètres et une largeur (définie dans une direction parallèle au vecteur *̅k̅*̅ du repère orthogonal [O;*̅i̅*̅;*̅j̅*̅;*̅k̅*̅]) comprise par exemple entre 3 nanomètres et 1 micromètre, ou avantageusement comprise entre 3 et 20 nanomètres. Dans l'exemple illustré sur la figure 1A, les barreaux 120a, 120b, 120c, 120d, sont suspendus, et ne sont pas en contact avec le substrat et en particulier avec la couche isolante 102. Il existe ainsi un espace entre chacun des barreaux 120a, 120b, 120c, 120d, et entre le substrat 100 et les barreaux 120a, 120b, 120c, 120d. Selon une possibilité d'agencement, au moins un premier barreau 120a et au moins un deuxième barreau 120b distinct ou disjoint du premier barreau, sont alignés dans une direction réalisant un angle non-nul, par exemple de 90°, avec le plan principal de la couche semi-conductrice 101 ou de la couche isolante 102. Dans une direction sensiblement parallèle au plan principal de la couche isolante 102, un troisième barreau semi-conducteur 120c, et un quatrième barreau semi-conducteur 120d, sont alignés respectivement, avec le premier barreau 120a et avec le deuxième barreau 120b.

Ensuite (figure 1B), on réalise un dépôt d'une couche de diélectrique 140 de grille sur la structure semi-conductrice 105, et en particulier autour des barreaux 120a, 120b, 120c, 120d, et sur les blocs semi-conducteurs 110 et 130. La couche diélectrique 140 peut être par exemple une couche d'oxyde tel que du SiO₂ ou du HfO₂.

Puis, on réalise un dépôt d'une couche dite « de réserve » ou « de résist » (resist selon la terminologie anglo-saxonne) à base d'un matériau précurseur 150 comportant au moins un élément métallique. Le matériau précurseur 150 choisi est apte à être décomposé en au moins un matériau métallique après avoir été exposé à un faisceau d'électrons.

Selon une possibilité, le matériau précurseur 150 peut être un composé de nature minérale comportant au moins un élément métallique et un ou plusieurs autres éléments non-métalliques. Le matériau de réserve peut être un composé fluoré comportant au moins un élément métallique, et peut être choisi par exemple parmi l'un des composés suivants : BaF₂, SrF₂, MgF₂, LaF₃, FeF₂, CrF₂, AlF₃.

Selon une autre possibilité, le matériau précurseur de réserve 150 peut être un matériau organométallique. Ce matériau organométallique peut être de la forme suivante : 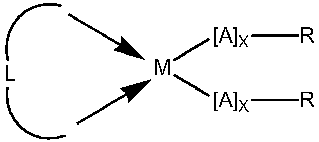 avec,
- M : un métal qui peut être choisi parmi les métaux suivants : platine, cuivre, rhodium, tungstène, iridium, argent, or, tantale, palladium ;
- A : un atome ou une molécule qui peut être choisie parmi la liste suivante : oxygène, soufre, groupement amine, groupement amide, groupement ester,
- X : un nombre choisi entre 0 et 1,
- L : un ligand,
- R : un groupement fluoro-organique.

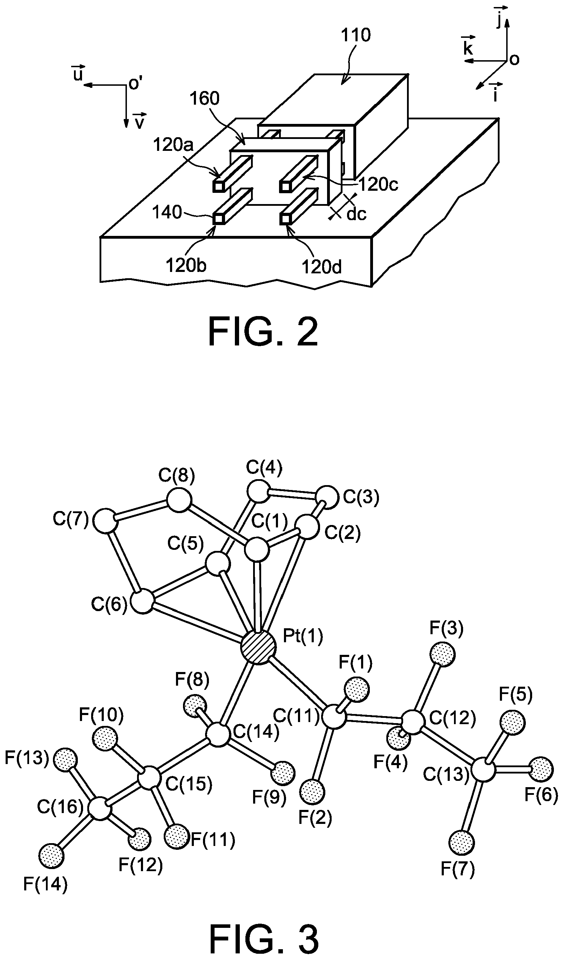

Selon une mise en oeuvre particulière, le matériau organométallique peut être par exemple formé à base de (C₃F₇)₂PtC₈H₁₂ dont la molécule est illustrée figure 3. Cette molécule de (C₃F₇)₂PtC₈H₁₂ peut être synthétisée à partir de C₈H₁₂Br₂Pt dont la molécule peut avoir la forme suivante : 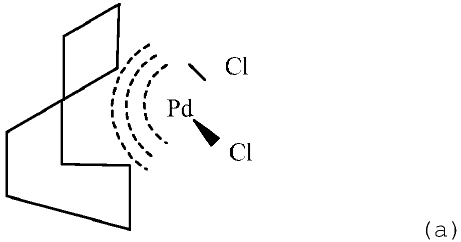 ou de C₈H₁₂Cl₂Pd dont la molécule peut avoir la forme suivante :

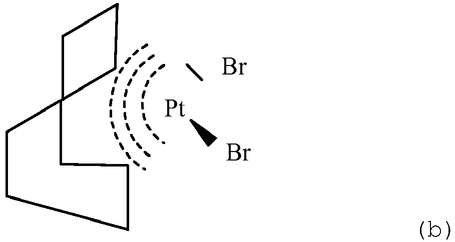

La couche de réserve à base de matériau précurseur 150 peut être déposée par exemple par CVD (CVD pour « chemical vapour deposition » ou « dépôt chimique en phase vapeur » sur la structure 105 et éventuellement sur les blocs 110 et 130 (figure 1C). L'épaisseur de matériau précurseur 150 déposée peut être supérieure à la hauteur des blocs semi-conducteurs 110 et 130 et par exemple comprise entre 10 et 100 nanomètres. Le dépôt peut être tel que le matériau précurseur 150 recouvre les blocs 110 et 130 et enrobe, ou entoure les barreaux 120a, 120b, 120c, 120d. Selon une possibilité, dans le cas où le matériau précurseur 150 est un matériau organométallique, ce dernier peut être déposé par MOCVD (MOCVD pour « Metal Organic Chemical Vapor Deposition »).

Ensuite, on réalise au moins un motif de grille sur une partie de la structure 105, à partir de la couche de réserve à base de matériau précurseur 150, en exposant une partie de cette couche de réserve à au moins un faisceau d'électrons 155. Le faisceau d'électrons 155 peut en particulier permettre de pénétrer à travers la structure semi-conductrice 105, et d'atteindre des parties du matériau précurseur 150 situées sous cette structure 105 ou sous les barreaux 120a, 120b, 120c, 120d. A l'aide de l'action du faisceau 155, certaines parties de la couche de réserve à base de matériau précurseur 150 qui sont situées entre les barreaux 120a et 120b, ou/et entre les barreaux 120c et 120d, ou/et entre respectivement, le barreau 120b et le substrat et/ou entre le barreau 120d et le substrat, peuvent être atteintes. Le retrait de parties non exposées au faisceau 155 de la couche de réserve à base de matériau précurseur 150 est également facilité et d'avantage précis qu'avec des procédés de retraits classiques, mettant par exemple en oeuvre une gravure anisotrope à l'aide d'un plasma ou une gravure isotrope chimique. Le faisceau 155 peut être éventuellement issu d'un ensemble de plusieurs faisceaux d'électrons.

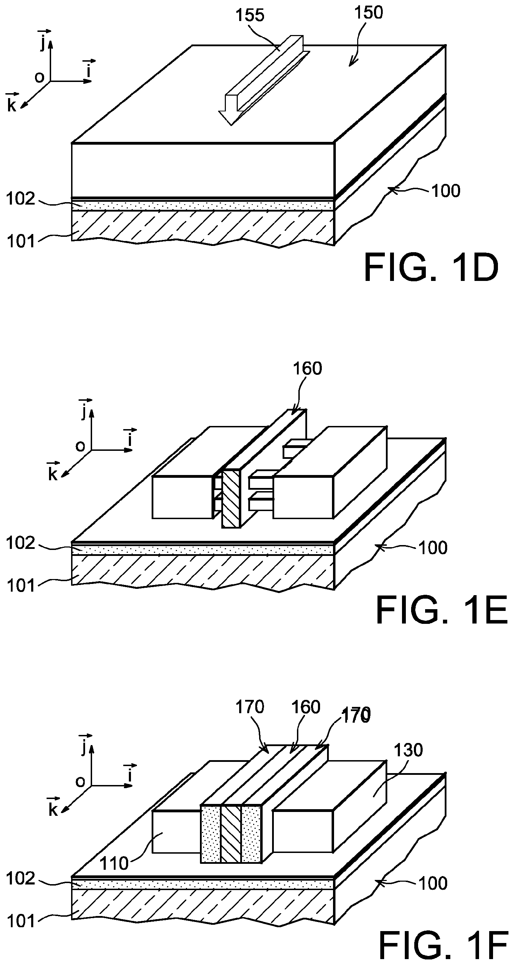

Selon une possibilité, l'exposition de la couche de réserve à base de matériau précurseur 150 peut être réalisée sans masque, par écriture directe du faisceau 155 dans le matériau précurseur 150 (figure 1D).

Selon une variante (non représentée), l'exposition de la couche de réserve à base de matériau précurseur 150 à un faisceau d'électrons, peut être réalisée à travers un masque comportant par exemple une ouverture reproduisant le motif de grille que l'on souhaite former dans la couche de matériau précurseur 150.

Les parties de la couche de réserve à base de matériau précurseur 150 exposées au faisceau 155, sont destinées à être transformées en zones métalliques. Les parties de la couche de réserve à base de matériau précurseur 150 exposées au faisceau 155, peuvent former un contour fermé autour respectivement des barreaux 120a, 120b, 120c, 120d.

Dans un cas où le matériau précurseur 150 de réserve est un composé minéral comportant un élément métallique et un ou plusieurs autres éléments non métalliques, l'action du faisceau 155 d'électrons est susceptible de décomposer le matériau précurseur 150 et de provoquer une évaporation desdits autres éléments non métalliques. Après exposition au faisceau 155 d'électrons, les parties de la couche de matériau précurseur 150 qui ont été exposées forment des zones métalliques. Dans un cas par exemple où le matériau 150 de réserve est un composé minéral fluoré comportant un élément métallique, choisi par exemple parmi l'un des matériaux suivants : BaF₂, SrF₂, MgF₂, LaF₃, FeF₂, CrF₂, AlF₃, l'action du faisceau 155 d'électrons peut provoquer une évaporation du Fluor et une décomposition dudit composé fluoré en au moins un matériau métallique. Ainsi, selon plusieurs exemples : les parties de la couche de réserve à base de matériau 150 exposées au faisceau 155 sont susceptibles de former des zones métalliques à base de Ba pour un matériau précurseur à base de BaF₂, ou de former des zones métalliques à base de Sr pour un matériau précurseur à base de SrF₂, ou de former des zones métalliques à base de Mg pour un matériau précurseur à base de MgF₂, ou de former des zones métalliques à base de La pour un matériau précurseur à base de LaF₃, ou de former des zones métalliques à base de Fe pour un matériau précurseur à base de FeF₂, ou de former des zones métalliques à base de Cr pour un matériau précurseur à base de CrF₂, ou de former des zones métalliques à base de Al pour un matériau précurseur à base de AlF₃.

Dans le cas où le matériau précurseur 150 est un matériau organométallique, après l'étape d'exposition, on effectue en outre une réduction du matériau organométallique, de manière à former des zones métalliques aux endroits de la couche de matériau 150 qui ont été exposés au faisceau 155. Cette réduction peut comporter par exemple plusieurs étapes de chauffage et de refroidissement, successives. La réduction peut comprendre par exemple une première étape, de chauffage puis de refroidissement, le tout sous une atmosphère inerte comportant un gaz tel que du diazote. Une seconde étape, de chauffage puis de refroidissement, le tout sous atmosphère comportant du dioxygène, par exemple sous atmosphère d'air, peut être ensuite effectuée. La réduction peut ensuite comprendre une troisième étape, de chauffage puis de refroidissement, le tout sous atmosphère comportant un gaz réducteur, par exemple comprenant du dihydrogène.

Ensuite, on effectue une étape de développement de la couche de réserve, lors de laquelle on retire les parties de cette couche de réserve à base du matériau précurseur 150, qui n'ont pas été exposées au faisceau 155.

Dans le cas d'un matériau précurseur 150 organométallique, ce retrait peut être effectué par lavage par exemple à l'aide de dichlorométhane ou par sublimation. Les parties de la couche de matériau organométallique exposées au faisceau 155 forment, après réduction, un bloc de grille 160 à base du métal M (avec M le métal présent dans la molécule d'organométallique précédemment décrite) enrobant les barreaux 120a, 120b, 120c, 120d, sur une partie de leur longueur. Dans le cas où le matériau précurseur 150 est un composé de nature minérale, par exemple un composé fluoré comportant un élément métallique tel que du BaF₂, du SrF₂, du MgF₂, ou du LaF₃, ce retrait peut être effectué par exemple par dissolution dans de l'eau. Dans un autre cas où le matériau précurseur 150 est un composé tel que du FeF₂, CrF₂, AlF₃, le retrait peut être effectué par exemple à l'aide d'une solution oxydante, par exemple de type dit « Caro 3:1 » formée d'un mélange de 3 volumes d'acide sulfurique par exemple à 96 % pour un volume d'eau oxygénée par exemple à 30 % ou d'acide nitrique fumant (figure 1E).

La figure 2 illustre le dispositif microélectronique après formation de la grille 160, selon une vue en coupe suivant un plan [O';*̅u̅*̅;*̅v̅*̅] (indiqué sur la figure 1E). La grille 160 est disposée de sorte que des zones de métal de grille encerclent ou entourent les barreaux 120a, 120b, 120c, 120d, sur au moins une partie de leur longueur, ou forment une bague ou un contour fermé autour des barreaux 120a, 120b, 120c, 120d. Le procédé de formation de la grille 160 mis en oeuvre suivant l'invention permet d'obtenir une grille que l'on qualifiera d'« auto-alignée » dans la mesure où la dimension critique de la grille ou la côte de grille (référencée dc sur la figure 2 et mesurée dans une direction parallèle au vecteur *̅i̅*̅ du repère orthogonal [O ; *̅i̅*̅ ; *̅j̅*̅ ; *̅k̅*̅]) est uniforme ou sensiblement uniforme de part et d'autre des barreaux 120a, 120b, 120c, 120d, que l'on se place par exemple dans un plan parallèle au plan [O ; *̅i̅*̅ ; *̅k̅*̅] et situé au-dessus des barreaux 120a et 120c, ou dans un plan parallèle au plan [O ; *̅i̅*̅ ; *̅k̅*̅] et situé entre d'une part les barreaux 120a et 120c, et d'autre part les barreaux 120b, 120d, ou bien que l'on soit dans un plan parallèle au plan [O ; *̅i̅*̅ ; *̅k̅*̅] et situé entre, d'une part les barreaux 120b et 120d, et d'autre part le substrat 100 (figure 2).

On peut ensuite former des espaceurs 170 (« spacers » selon la terminologie anglo-saxonne) isolants pour la grille 160 en déposant un matériau diélectrique, par exemple à base de Si₃N₄, entre la grille 160 et chacun des blocs 110 et 130. Ce dépôt peut être suivi d'un retrait du matériau diélectrique dans une partie située au dessus des blocs 110 et de la grille 160, par exemple à l'aide d'une étape de CMP (CMP pour Chemical Mechanical Polishing ou polissage mécano-chimique) (figure 1F).

Le procédé microélectronique suivant l'invention, de formation d'au moins une structure de grille de transistor à l'aide d'un matériau précurseur 150 organométallique ou formé d'un composé de nature minérale comportant au moins un élément métallique et un ou plusieurs autres éléments non-métalliques, sur une structure semi-conductrice comportant au moins un bloc semi-conducteur dans lequel une structure de canal est destinée à être formée, n'est pas limité à celui qui vient d'être détaillé, et en particulier à une réalisation sur une structure telle que la structure 105 décrite précédemment en liaison avec la figure 1A.

Le procédé microélectronique suivant l'invention peut s'appliquer à tout type de structure semi-conductrice destinée à réaliser un canal ou un canal à plusieurs branches ou plusieurs canaux. Le procédé microélectronique peut s'appliquer à la formation de grilles dites partiellement enrobantes, c'est-à-dire de grilles comportant aux moins deux régions appartenant à des plans distincts. Le procédé microélectronique s'applique en particulier à tout type de grille dite « totalement enrobante » ou GAA (GAA pour « Gate All Around ») pour laquelle le matériau de grille encercle ou entoure ou forme une bague autour d'au moins un barreau semi-conducteur dans lequel un courant est destiné à circuler. La réalisation d'une grille GAA, peut nécessiter d'avoir à effectuer un retrait de matériau dans certaines zones situées sous un barreau semi-conducteur, et/ou requiert un procédé de retrait précis du matériau de grille dans des zones indésirables afin d'obtenir une côte de grille uniforme autour du barreau semi-conducteur. Une telle précision de retrait est permise par les étapes d'exposition de certaines zones du matériau précurseur 150 et de retrait des zones non-exposées de ce matériau précurseur 150, telles que décrites précédemment.

De même, le procédé microélectronique s'applique en particulier à la formation de grilles sur des structures semi-conductrices reposant sur un substrat, formées d'un ou plusieurs blocs ou barreaux semi-conducteurs et comportant au moins une cavité ou/et au moins une ouverture ou/et formant au moins un espace, par exemple entre lesdits barreaux semi-conducteurs ou/et entre au moins un desdits barreaux semi-conducteurs et le substrat.

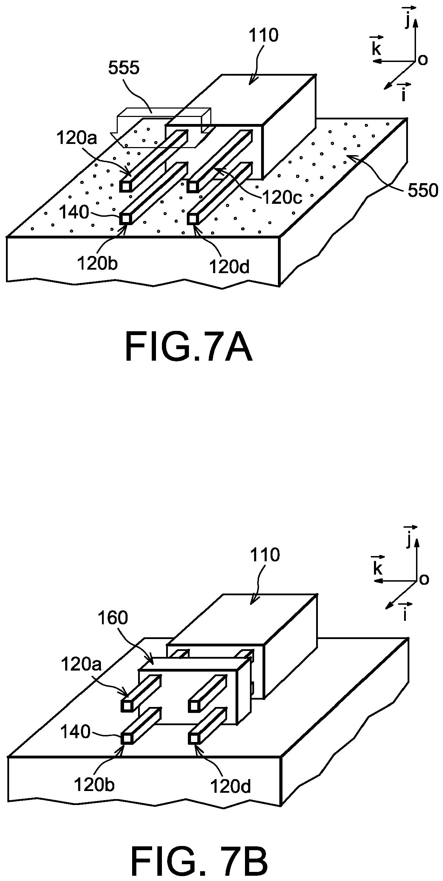

Selon une variante de formation de la grille 160 décrite précédemment, cette dernière peut être réalisée à l'aide d'un dépôt assisté par faisceau d'électrons 555. Le faisceau d'électrons 555 peut être par exemple du type de celui utilisé dans le document : « Metal delocalization and surface decoration in direct write nanolithography by electron beam induced deposition, Vidyut Gopal et al. Applied Physics letters volume 85, n°1, July 2004*, 5^{th} »* ou dans le document : « Integrated tungsten nanofiber field emission cathodes selectively grown by nanoscale electron beam induced deposition, X. Yang et al., Applied Physics letters 86, 183106 2005 *ou dans le document* « Growth and simulation of high aspect ratio nanopillars by secondary electron induced deposition », Journal of Vacuum Science & technology B: Microelectronics and Nanometer Structures, November 2005, vol. 23, Issue, p 2825-2832*.* L'énergie pour accélérer le faisceau d'électrons 555 peut être comprise entre plusieurs centaines d'eV et plusieurs dizaines de keV. Pour cette variante, après le dépôt de la couche de diélectrique 140 de grille, on injecte, sous un faisceau d'électrons 555, un précurseur 550 sous forme de vapeur, comportant au moins un élément métallique. La structure 105 est ainsi placée dans une vapeur de précurseur 550 (figure 7A). Le précurseur 550 choisi, est apte à être décomposé en au moins un matériau métallique après avoir été exposé à un faisceau d'électrons. Dans un cas par exemple où le matériau de grille que l'on souhaite déposer est du W, le précurseur 550 peut être du WF₆ sous forme de vapeur injecté à température ambiante. Selon un autre cas, par exemple, où le matériau de grille que l'on souhaite déposer est du Pt, le précurseur 550 peut être du (CH3)₃CH₃C₅H₄Pt chauffé pour être sous forme de vapeur. Le faisceau d'électrons 555 est dirigé vers des parties de la structure 105 sur lesquelles on souhaite effectuer le dépôt. Le précurseur 550 peut être adsorbé à la surface de la structure 105 et décomposé par le faisceau 555 de manière à former des dépôts à base dudit élément métallique sur la structure 105. L'exposition du précurseur 550 au faisceau 555 peut permettre de concentrer l'élément métallique destiné à jouer le rôle de matériau de grille aux endroits du dispositif insolés par le faisceau d'électrons 555. Les dépôts à base dudit élément métallique peuvent former des contours fermés autour respectivement des barreaux 120a, 120b, 120c, 120d. La grille 160 est disposée de sorte que des zones de métal de grille encerclent ou entourent les barreaux 120a, 120b, 120c, 120d, sur au moins une partie de leur longueur, ou forment une bague ou un contour fermé autour des barreaux 120a, 120b, 120c, 120d (figure 7B).

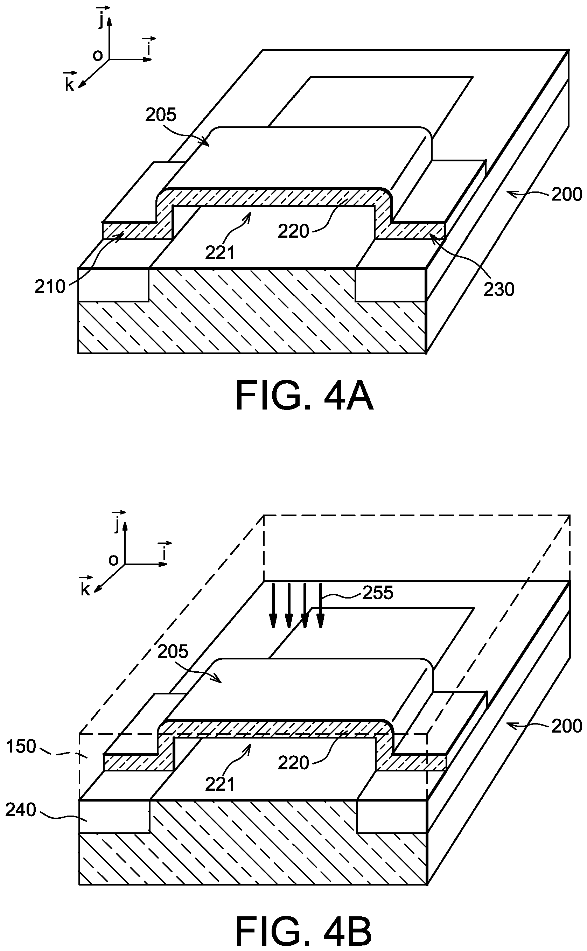

Selon une autre variante de mise en oeuvre du procédé microélectronique suivant l'invention, on peut former une grille de transistor, à l'aide d'une couche de réserve à base de matériau précurseur 150 tel que décrit plus haut, à partir d'un dispositif microélectronique tel qu'illustré sur la figure 4A. Ce dispositif microélectronique comprend une structure semi-conductrice 205 en forme de pont, reposant sur un substrat 200, par exemple de type SOI. La structure 205 peut être obtenue par exemple à l'aide d'un procédé tel que décrit dans le document US 2005/0037603A1. La structure 205 comporte un barreau semi-conducteur 220 suspendu, qui n'est pas en contact avec le substrat 200 et qui est destiné à former un canal de transistor. La longueur du barreau 220 peut être comprise par exemple entre 50 nanomètres et 1 micromètre, ou par entre 40 nanomètres et 300 nanomètres. Le barreau 220 peut avoir une épaisseur (définie sur la figure 4A dans une direction parallèle au vecteur *̅j̅*̅ d'un repère orthogonal [O ; *̅i̅*̅ ; *̅j̅*̅ ; *̅k̅*̅]) comprise par exemple entre 3 et 200 nanomètres, ou avantageusement comprise entre 3 et 20 nanomètres et une largeur (définie dans une direction parallèle au vecteur *̅k̅*̅ du repère orthogonal [O; *̅i̅*̅; *̅j̅*̅; *̅k̅*̅]) par exemple entre 3 nanomètres et 1 micromètre, ou avantageusement comprise entre 3 et 20 nanomètres. La structure 205 est reliée ou rattachée au substrat par l'intermédiaire de blocs semi-conducteurs 210 et 230 destinés à jouer le rôle respectivement, de région de source et de région de drain. La structure 205 forme avec la couche supérieure du substrat sur laquelle elle repose, un espace 221 ou une ouverture 221 ou une cavité 221.

On réalise sur ladite structure 205, un dépôt d'une couche de diélectrique 240 de grille.

On réalise ensuite sur ladite structure 205, un dépôt de la couche de réserve à base de matériau précurseur 150 (matérialisée à l'aide de traits discontinus sur la figure 4B) sensible à l'effet de projection(s) d'électrons. Le dépôt du matériau précurseur 150 est réalisé de manière à combler au moins partiellement la cavité 221.

Puis, on expose la couche de réserve à base de matériau précurseur 150 à un faisceau d'électrons 255, et notamment une zone dudit matériau précurseur 150 formant une bague autour du barreau semi-conducteur 220. Des régions de la couche de réserve à base de matériau précurseur 150 situées dans la cavité 221, sous le barreau semi-conducteur 220, peuvent ainsi être exposées au faisceau d'électrons.

Dans le cas où le matériau précurseur 150 est un matériau organométallique, après exposition au faisceau d'électrons, on peut effectuer une réduction de l'organométallique, de manière à former une zone métallique au niveau des parties du matériau précurseur 150 exposées au faisceau.

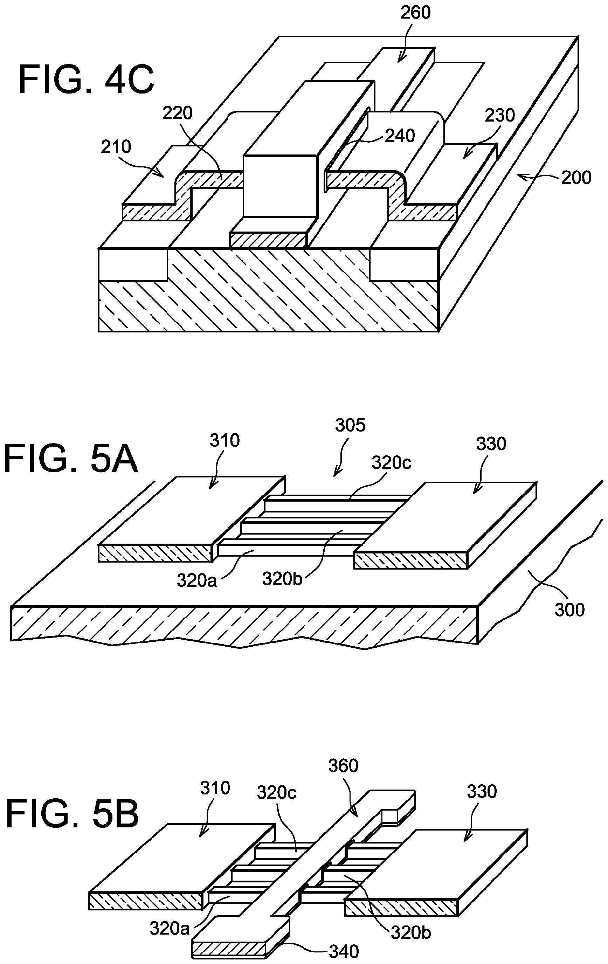

Ensuite, on effectue un retrait de zones non-exposées de la couche de réserve. Ce retrait peut être réalisé par exemple par lavage ou par sublimation dans le cas où le matériau précurseur 150 est un organométallique. Dans le cas où le matériau précurseur 150 est un composé de nature minérale comportant un élément métallique, par exemple un composé fluoré tel que du BaF₂, du SrF₂, du MgF₂, ou du LaF₃, ce retrait peut être effectué par exemple par dissolution dans de l'eau. Dans un autre cas où le matériau précurseur 150 est un composé tel que du FeF₂, CrF₂, AlF₃, le retrait peut être effectué par exemple à l'aide d'une solution oxydante, par exemple de type dit « Caro 3:1 » formée d'un mélange de 3 volumes d'acide sulfurique par exemple à 96% pour un volume d'eau oxygénée par exemple à 30%, ou d'acide nitrique fumant. Les parties de la couche de réserve à base de matériau précurseur 150 déposées sous le barreau semi-conducteur 220, qui se trouvent dans l'espace ou la cavité 221 et qui n'ont pas été exposées au faisceau 255, sont retirées. La zone métallique forme une grille métallique 260, dite « enrobante », réalisant un contour fermé autour d'une portion du barreau semi-conducteur 220 (figure 4C). Selon une autre possibilité de réalisation, la grille métallique 260 « enrobante » peut être formée par un dépôt (du type de celui décrit précédemment en liaison avec les figures 7A-7C) par faisceau d'électrons à l'aide d'un précurseur métallique sous forme de vapeur.

Selon une autre variante de mise en oeuvre du procédé microélectronique suivant l'invention, on peut former une grille de transistor dite « partiellement enrobante », à l'aide du matériau précurseur 150 tel que décrit plus haut, à partir d'un dispositif microélectronique tel qu'illustré sur la figure 5A. Ce dispositif microélectronique comprend une structure semi-conductrice 305 comportant plusieurs barreaux semi-conducteurs 320a, 320b, 320c, distincts et juxtaposés sur un substrat 300, par exemple de type SOI. La structure 305 peut être obtenue par exemple à l'aide d'un procédé tel que décrit dans le document : « Nanoscale CMOS Spacer FinFET for the Terabit Era », Choi et al., IEEE Electron device letters, vol. 23, n°1, january 2002*.* Cette structure semi-conductrice 305 relie un premier bloc semi-conducteur 310 destiné à jouer le rôle de région de source et un deuxième bloc semi-conducteur 330 destiné à jouer le rôle de région de drain.

On réalise sur ladite structure 305, un dépôt d'une couche de matériau diélectrique 340 de grille. Puis, on grave cette couche, de manière à ne conserver ledit matériau diélectrique 340 que sur une partie des barreaux 320a, 320b, 320c.

Ensuite, on effectue le dépôt de la couche réserve à base de matériau précurseur 150 sur la structure 305. Le matériau précurseur 150 peut être déposé sur la structure 305, de manière à recouvrir le dessus des barreaux 320a, 320b, 320c, ainsi que les flancs de ces derniers.

Puis, on expose des zones de la couche de réserve à base de matériau précurseur 150 à un faisceau d'électrons.

Dans un cas où le matériau précurseur 150 est un matériau organométallique, on effectue ensuite une réduction du matériau organométallique. Un dépôt métallique 360 est formé aux endroits de la couche de matériau précurseur 150 qui ont été exposés au faisceau d'électrons. On retire ensuite les zones de la couche de matériau précurseur 150 non-exposées au faisceau d'électrons. Le dépôt métallique 360 réalisé, forme une grille recouvrant une partie du dessus et des flancs des barreaux 320a, 320b, 320c (figure 5B).

Selon une variante de l'exemple de procédé qui vient d'être décrit, cette variante ne faisant pas partie de la présente invention, la grille 360, peut être formée à l'aide d'un matériau précurseur organométallique photosensible. Cet organométallique photosensible est choisi de manière à pouvoir être décomposé en au moins un matériau métallique sous l'effet d'un faisceau de rayons lumineux, par exemple un faisceau de rayons UV. Le matériau organométallique photosensible peut être par exemple celui décrit précédemment en liaison avec figure 3. Pour cette variante, on effectue un dépôt du matériau organométallique photosensible sur la structure 305, puis une exposition de certaines zones de la couche de matériau organométallique photosensible à l'aide d'un faisceau de rayons UV. On effectue ensuite une réduction du matériau organométallique, de manière à former une ou plusieurs zones métalliques sur ladite structure 305 au niveau desdites zones exposées au faisceau de rayons UV. Les zones de la couche de matériau organométallique photosensible qui n'ont pas été exposées sont ensuite retirées.

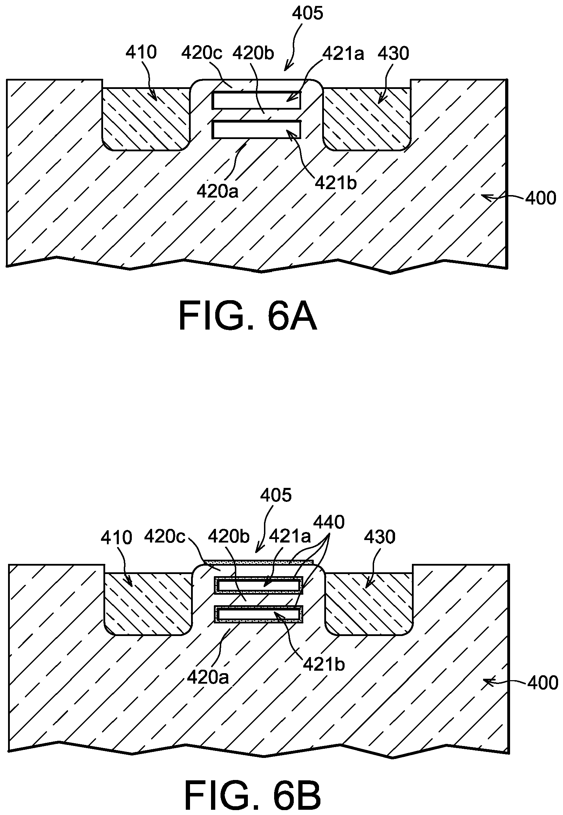

Une autre variante de mise en oeuvre du procédé microélectronique suivant l'invention, comprend la formation d'une grille de transistor, à l'aide du matériau précurseur 150, à partir d'un dispositif microélectronique tel qu'illustré sur la figure 6A. Ce dispositif microélectronique comprend une structure semi-conductrice 405 dite « multi-ponts ». La structure 405 peut être obtenue à l'aide d'un procédé tel que décrit dans le document « A Novel MBC (Multi-Bridge-Channel) MOSFET : Fabrication technologies and characteristics, Kim et al., IEEE transactions on nanotechnology, vol.2, n°4, décembre 2003*.* La structure « multi-ponts » 405 repose sur un substrat 400 et est formée de plusieurs barreaux semi-conducteurs 420a, 420b, 420c superposés, reliant une région de source 410 et une deuxième région de drain 430. La structure 405 comporte des cavités ou des ouvertures 421a et 421b respectivement entre les barreaux 420a et 420b et entre les barreaux 420b et 420c.

On réalise un diélectrique 440 de grille, par exemple par oxydation des barreaux semi-conducteurs 420a, 420b, 420c, sur la structure 405 et dans les cavités 421a et 421b (figure 6B).

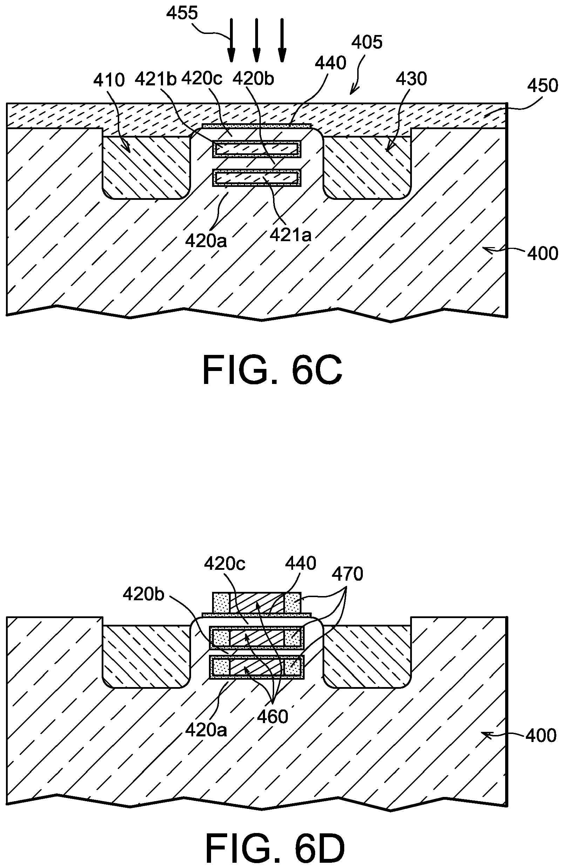

On réalise ensuite sur ladite structure 405, et dans les cavités 421a et 421b, un dépôt d'une couche de réserve à base d'un matériau précurseur 150. Le matériau précurseur 150 choisi, peut être tel que décrit plus haut et susceptible de se décomposer en au moins un matériau métallique suite à une exposition à un faisceau d'électrons. Puis, on expose des zones de la couche de réserve à base du matériau précurseur 150 à un faisceau d'électrons 455, en fonction d'un motif de grille que l'on souhaite réaliser. Des zones du matériau de réserve 150 situées à l'intérieur des cavités 421a et 421b sont ainsi exposées au faisceau 455 (figure 6C). Dans un cas où le matériau précurseur 150 est un matériau organométallique, on effectue ensuite une réduction du matériau organométallique, de manière à former des zones métalliques 460 aux endroits qu'occupaient le matériau 150 et qui ont été exposées au faisceau 455. Puis, on retire les zones non-exposées le matériau 150 aux endroits qui n'ont pas été exposés au faisceau 455. Les zones métalliques 460 forment une grille de type GAA entourant ou enrobant les barreaux 420a, 420b, 420c. Des espaceurs isolants 470 peuvent être ensuite réalisés par exemple par dépôt de nitrure ou par formation d'un oxyde de silicium (figure 6D).

## Revendications

1. Procédé de réalisation d'un dispositif microélectronique à un ou plusieurs transistors, comprenant la réalisation d'au moins une grille (160, 260, 360, 460) de transistor(s) sur une structure semi-conductrice (105, 205, 305, 405) comportant un ou plusieurs barreaux (120a, 120b, 120c, 120d, 220, 320a, 320b, 320c, 420a, 420b, 420c) aptes à jouer le rôle d'un ou plusieurs canaux de transistors, la réalisation de ladite grille comprenant les étapes de :
a) dépôt sur au moins une partie de ladite structure semi-conductrice (105, 205, 305, 405), d'au moins une couche à base d'un matériau précurseur (150) organométallique,
b) exposition d'une ou plusieurs zones de la couche à base du matériau précurseur (150) organométallique à au moins un faisceau d'électrons,
c) réduction du matériau précurseur (150) organométallique de manière à former une ou plusieurs zones (160, 260, 360, 460) métalliques sur ladite structure au niveau desdites zones exposées au(x) faisceau(x).

2. Procédé microélectronique selon la revendication 1, dans lequel, ledit matériau précurseur organométallique (150, 250, 350, 450) est à base du composé suivant ou de la molécule suivante : 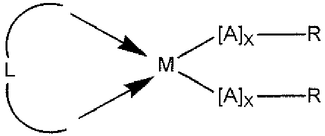 avec :
- M un métal qui peut être choisi parmi les métaux suivants : platine, cuivre, rhodium, tungstène, iridium, argent, or, tantale, palladium,
- A un atome ou une molécule qui peut être choisie parmi la liste suivante : oxygène, soufre, groupement amine, groupement amide, groupement ester,
- X un nombre choisi entre 0 et 1,
- L un ligand,
- R un groupement fluoro-organique, les zones métalliques formées à l'étape c) étant à base du métal M.

3. Procédé de réalisation d'un dispositif microélectronique à un ou plusieurs transistors, comprenant la réalisation d'au moins une grille (160, 260, 360, 460) de transistor(s) sur une structure semi-conductrice (105, 205, 305, 405) comportant un ou plusieurs barreaux (120a, 120b, 120c, 120d, 220, 320a, 320b, 320c, 420a, 420b, 420c) aptes à jouer le rôle d'un ou plusieurs canaux de transistors, la réalisation de ladite grille comprenant les étapes de :
a) dépôt sur au moins une partie de ladite structure semi-conductrice, d'au moins une couche de matériau précurseur (150) à base d'un composé de nature minérale comportant au moins un élément métallique et apte à être décomposé en au moins un matériau métallique sous l'effet d'un faisceau d'électrons,
b) exposition d'une ou plusieurs zones de la couche de matériau précurseur (150), à au moins un faisceau d'électrons (155, 255, 455), de manière à former sur la structure semi-conductrice (105, 205, 305, 405), une ou plusieurs zones métalliques (160, 260, 360, 460) à base dudit matériau au niveau desdites zones exposées au(x) faisceau(x).

4. Procédé de réalisation d'un dispositif microélectronique selon la revendication 3, ledit composé étant un composé fluoré.

5. Procédé de réalisation d'un dispositif microélectronique selon la revendication 4, ledit composé étant choisi parmi l'un des composés suivants : BaF₂, SrF₂, MgF₂, LaF₃, FeF₂, CrF₂, AlF₃.

6. Procédé de réalisation d'un dispositif microélectronique selon l'une des revendications 1 à 5, comprenant en outre après exposition audit faisceau d'électrons : - le retrait de zones non-exposées de la couche de matériau précurseur (150).

7. Procédé de réalisation d'un dispositif microélectronique selon l'une des revendications 1 à 6, dans lequel la structure repose sur un substrat et comporte au moins une cavité (221, 421a, 421b), ou au moins une ouverture, ou au moins un espace entre au moins deux desdits barreaux semi-conducteurs (420c, 420b, 420a) ou/et entre au moins un barreau semi-conducteur (220) et le substrat (200), ledit dépôt étant réalisé de manière à combler au moins une zone de ladite cavité (221, 421a, 421b) ou dudit espace ou de ladite ouverture, à l'aide dudit matériau précurseur (150).

8. Procédé de réalisation d'un dispositif microélectronique selon la revendication 7, comprenant en outre : le retrait au moins partiel du matériau précurseur (150) dans ladite zone comblée.

9. Procédé de réalisation d'un dispositif microélectronique à un ou plusieurs transistors, comprenant la réalisation d'au moins une grille (160,260,360,460) de transistor(s) sur une structure semi-conductrice (105, 205, 305, 405) comportant un ou plusieurs barreaux (120a, 120b, 120c, 120d, 220, 320a, 320b, 320c, 420a, 420b, 420c) aptes à jouer le rôle d'un ou plusieurs canaux de transistors, la réalisation de ladite grille comprenant les étapes de :
a) placement de la structure semi-conductrice (105,205,305,405) dans une vapeur d'un matériau précurseur apte à être décomposé en au moins un matériau métallique sous l'effet d'un faisceau d'électrons,
b) exposition localisée d'une ou plusieurs régions de ladite structure semi-conductrice à au moins un faisceau d'électrons, de manière à former une ou plusieurs zones métalliques (160, 260, 360, 460) à base dudit matériau métallique sur lesdites régions de ladite structure semi-conductrice exposées au faisceau.

10. Procédé de réalisation d'un dispositif microélectronique selon la revendication 1 à 9, dans lequel ladite structure (305) comporte un barreau semi-conducteur ou plusieurs barreaux semi-conducteurs distincts (320a, 320b, 320c), reposant sur un substrat (300).

11. Procédé de réalisation d'un dispositif microélectronique selon la revendication 1 à 10, dans lequel ladite structure (105, 205) comprend au moins un premier bloc semi-conducteur (110) et au moins un deuxième bloc semi-conducteur (130) reposant sur un substrat, un ou plusieurs desdits barreaux semi-conducteurs (120a, 120b, 120c, 120d, 220) reliant le premier bloc (110) et le deuxième bloc (130), lesdits barreaux semi-conducteurs étant suspendus au-dessus du substrat (100, 200) et/ou n'étant pas en contact avec le substrat.

12. Procédé de réalisation d'un dispositif microélectronique selon l'une des revendications 1 à 11, dans lequel ladite structure semi-conductrice (105, 405) comprend au moins deux barreaux (120a, 120c, 120d, 420a, 420b, 420c) alignés dans une direction réalisant un angle non nul avec le plan principal du substrat (100, 400), et disjoints.

13. Procédé de réalisation d'un dispositif microélectronique selon l'une des revendications 1 à 12, dans lequel la structure semi-conductrice comprend au moins deux barreaux, alignés (120b, 120d, 220a, 220b, 220c) dans une direction parallèle avec un plan principal du substrat (120, 220), et disjoints.

14. Procédé de réalisation d'un dispositif microélectronique selon la revendication 1 à 13, dans lequel au moins une desdites zones métalliques (160, 260, 360, 460) comporte au moins deux régions situées dans des plans distincts.

15. Procédé de réalisation d'un dispositif microélectronique selon la revendication 1 à 14, dans lequel au moins une desdites zones métalliques (160, 260, 360, 460) forme un contour fermé ou une bague autour d'au moins un desdits barreaux semi-conducteurs.

16. Procédé de réalisation d'un dispositif microélectronique selon l'une des revendications 1 à 15, comprend après formation de ladite structure et préalablement à l'étape a), le dépôt d'au moins une couche de diélectrique (140, 240, 340, 440) de grille.

## Patentansprüche

1. Verfahren zum Herstellen einer mikroelektronischen Vorrichtung mit einem oder mehreren Transistoren, umfassend das Ausbilden zumindest eines Transistor-Gate (160, 260, 360, 460) an einer Halbleiterstruktur (105, 205, 305, 405) mit einem oder mehreren Stäben (120a, 120b, 120c, 120d, 220, 320a, 320b, 320c, 420a, 420b, 420c), die dazu geeignet sind, die Rolle von einem oder mehreren Transistorkanälen zu übernehmen, wobei das Ausbilden des Gate die nachfolgenden Schritte umfasst:
a) Aufbringen von zumindest einer Schicht auf Basis eines metallorganischen Vorläufermaterials (150) auf zumindest einen Teil der Halbleiterstruktur (105, 205, 305, 405),
b) Bestrahlen eines oder mehrerer Bereiche der Schicht auf Basis des metallorganischen Vorläufermaterials (150) mit zumindest einem Elektronenstrahl,
c) Reduktion des metallorganischen Vorläufermaterials (150) so, dass ein oder mehrere metallische Abschnitte (160, 260, 360, 460) auf der Struktur im Bereich der mit dem/den Elektronenstrahl(en) bestrahlten Bereichen gebildet werden.

2. Mikroelektronisches Verfahren nach Anspruch 1, wobei das metallorganische Vorläufermaterial (150, 250, 350, 450) auf Basis der nachfolgenden Verbindung bzw. der nachfolgenden Moleküls besteht: 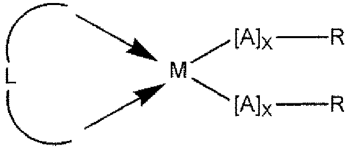 mit:
- M als ein Metall, das ausgewählt sein kann aus den nachfolgenden Metallen: Platin, Kupfer, Rhodium, Wolfram, Iridium, Silber, Golg, Tantal, Palladium,
- A als ein Atom bzw. Molekül, das ausgewählt sein kann aus der nachfolgenden Auflistung: Sauerstoff, Schwefel, Aminogruppe, Amidgruppe Estergruppe,
- X als eine ganze Zal zwischen 0 und 1,
- L als ein Ligand,
- R als eine fluororganische Gruppe, wobei die in Schritt c) gebildeten metallischen Bereiche auf Basis des Metalls M bestehen.

3. Verfahren zum Herstellen einer mikroelektronischen Vorrichtung mit einem oder mehreren Transistoren, umfassend das Ausbilden zumindest eines Transistor-Gate (160, 260, 360, 460) an einer Halbleiterstruktur (105, 205, 305, 405) mit einem oder mehreren Stäben (120a, 120b, 120c, 120d, 220, 320a, 320b, 320c, 420a, 420b, 420c), die dazu geeignet sind, die Rolle von einem oder mehreren Transistorkanälen zu übernehmen, wobei das Ausbilden des Gate die nachfolgenden Schritte umfasst:
a) Aufbringen von zumindest einer Schicht eines Vorläufermaterials (150) auf Basis einer mineralischen Verbindung auf zumindest einen Teil der Halbleiterstruktur, welche Verbindung zumindest ein metallisches Element enthält und dazu geeignet ist, unter der Wirkung eines Elektronenstrahls in zumindest ein metallisches Material zersetzt zu werden,
b) Bestrahlen eines oder mehrerer Bereiche der Schicht des Vorläufermaterials (150) mit zumindest einem Elektronenstrahl (155, 255, 455), so dass auf der Haltleiterstruktur (105, 205, 305, 405) ein oder mehrere metallische Bereiche (160, 260, 360, 460) auf Basis des Materials im Bereich der mit dem/den Elektronenstrahl(en) bestrahlten Bereichen gebildet werden.

4. Verfahren zum Herstellen einer mikroelektronischen Vorrichtung nach Anspruch 3, wobei die Verbindung eine Fluorverbindung ist.

5. Verfahren zum Herstellen einer mikroelektronischen Vorrichtung nach Anspruch 4, wobei die Verbindung ausgewählt ist aus einer der nachfolgenden Verbindungen: BaF₂, SrF₂, MgF₂, LaF₃, FeF₂, CrF₂, AlF₃.

6. Verfahren zum Herstellen einer mikroelektronischen Vorrichtung nach einem der Ansprüche 1 bis 5, ferner umfassend nach dem Bestrahlen mit dem Elektronenstrahl:
- Entfernen von nicht bestrahlten Bereichen der Vorläufermaterialschicht (150).

7. Verfahren zum Herstellen einer mikroelektronischen Vorrichtung nach einem der Ansprüche 1 bis 6, wobei die Struktur auf einem Substrat aufliegt und zumindest einen Hohlraum (221, 421a, 421b) oder zumindest eine Öffnung oder zumindest einen Raum zwischen zumindest zweien der Halbleiterstäbe (420c, 420b, 420a) und/oder zwischen zumindest einem Halbleiterstab (220) und dem Substrat (200) aufweist, wobei das Aufbringen so erfolgt, dass zumindest ein Bereich des Hohlraums (221, 421a, 421b) oder des Raums oder der Öffnung mit Hilfe des Vorläufermaterials (150) verfüllt wird.

8. Verfahren zum Herstellen einer mikroelektronischen Vorrichtung nach Anspruch 7, ferner umfassend:
- zumindest teilweises Entfernen des Vorläufermaterials (150) aus dem verfüllten Bereich.

9. Verfahren zum Herstellen einer mikroelektronischen Vorrichtung mit einem oder mehreren Transistoren, umfassend das Ausbilden zumindest eines Transistor-Gate (160, 260, 360, 460) an einer Halbleiterstruktur (105, 205, 305, 405) mit einem oder mehreren Stäben (120a, 120b, 120c, 120d, 220, 320a, 320b, 320c, 420a, 420b, 420c), die dazu geeignet sind, die Rolle von einem oder mehreren Transistorkanälen zu übernehmen, wobei das Ausbilden des Gate die nachfolgenden Schritte umfasst:
a) Anordnen der Halbleiterstruktur (105, 205, 305, 405) in einen Materialdampf eines Vorläufermaterials, das dazu geeignet ist, unter der Wirkung eines Elektronenstrahls in zumindest ein metallisches Material zersetzt zu werden,
b) bereichsweises Bestrahlen eines oder mehrerer Abschnitte der Halbleiterstruktur mit zumindest einem Elektronenstrahl, so dass ein oder mehrere Metallbereiche (160, 260, 360, 460) auf Basis des metallischen Materials an den mit dem Elektronenstrahl bestrahlten Abschnitten der Halbleiterstruktur gebildet werden.

10. Verfahren zum Herstellen einer mikroelektronischen Vorrichtung nach Anspruch 1 bis 9, wobei die Struktur (305) einen oder mehrere verschiedene Halbleiterstäbe (320a, 320b, 320c) aufweist, die auf einem Substrat (300) aufliegen.

11. Verfahren zum Herstellen einer mikroelektronischen Vorrichtung nach Anspruch 1 bis 10, wobei die Struktur (105, 205) zumindest einen ersten Halbleiterblock (110) und zumindest einen zweiten Halbleiterblock (130) aufweist, die auf einem Substrat aufliegen, wobei einer oder mehrere der Halbleiterstäbe (120a, 120b, 120c, 120d, 220) den ersten Block (110) und den zweiten Block (130) verbinden, wobei die Halbleiterstäbe über dem Substrat (100, 200) freitragend angeordnet sind und/oder nicht mit dem Substrat in Kontakt sind.

12. Verfahren zum Herstellen einer mikroelektronischen Vorrichtung nach einem der Ansprüche 1 bis 11, wobei die Halbleiterstruktur (105, 405) zumindest zwei Stäbe (120a, 120c, 120d, 420a, 420b, 420c) aufweist, die in einer Richtung, die einen Winkel ungleich null mit der Hauptebne des Substrats (100, 400) einschließt, fluchten und getrennt voneinander vorliegen.

13. Verfahren zum Herstellen einer mikroelektronischen Vorrichtung nach einem der Ansprüche 1 bis 12, wobei die Halbleiterstruktur zumindest zwei Stäbe (120b, 120d, 220a, 220b, 220c) aufweist, die in einer Richtung, die parallel zur Hauptebene des Substrats (120, 220) verläuft, fluchten und getrennt voneinander vorliegen.

14. Verfahren zum Herstellen einer mikroelektronischen Vorrichtung nach Anspruch 1 bis 13, wobei zumindest einer der Metallbereiche (160, 260, 360, 460) zumindest zwei Abschnitte aufweist, die in verschiedenen Ebenen liegen.

15. Verfahren zum Herstellen einer mikroelektronischen Vorrichtung nach Anspruch 1 bis 14, wobei zumindest einer der Metallbereiche (160, 260, 360, 460) eine geschlossene Kontur bzw. einen Ring um zumindest einen der Halbleiterstäbe bildet.

16. Verfahren zum Herstellen einer mikroelektronischen Vorrichtung nach einem der Ansprüche 1 bis 15, das nach Ausbilden der Struktur und vor dem Schritt a) das Aufbringen zumindest einer dielektrischen Gate-Schicht (140, 240, 340, 440) umfasst.

## Claims

1. A method for the fabrication of a microelectronic device with one or more transistors, which comprises the fabrication of at least one transistor gate (160, 260, 360, 460) on a semi-conducting structure (105, 205, 305, 405) that comprises one or more bars (120a, 120b, 120c, 120d, 220, 320a, 320b, 320c, 420a, 420b, 420c) designed to play the role of one or more transistor channels, where the fabrication of said gate comprises the steps:
a) deposition over at least part of said semi-conducting structure (105, 205, 305, 405), of at least one layer based on an organometallic precursor material (150),
b) exposure of one or more zones of the layer based on the organometallic precursor material (150) to at least one electron beam=,
c) reduction of the organometallic precursor material (150) so as to form one or more metallic zones (160, 260, 360, 460) on said structure at the level of said zones exposed to the beam or beams.

2. A microelectronic method according to claim 1, in which said organometallic precursor material (150, 250, 350, 450) is based on the following compound or on the following molecule: 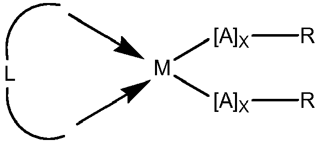 where:
- M is a metal that can be chosen from among the following metals - platinum, copper, rhodium, tungsten, iridium, silver, gold, tantalum and palladium,
- A is an atom or a molecule that can be chosen from the following list - oxygen, sulphur, the amine group, the amide group or the ester group,
- X is an a number chosen from 0 and 1,
- L is a ligand,
- R is a fluoro-organic group, where the metallic zones formed at stage c) are based on the metal M.

3. A method for the fabrication of a microelectronic device with one or more transistors, which comprises the fabrication of at least one transistor gate (160, 260, 360, 460) on a semi-conducting structure (105, 205, 305, 405) that comprises one or more bars (120a, 120b, 120c, 120d, 220, 320a, 320b, 320c, 420a, 420b, 420c) designed to play the role of one or more transistor channels, where the fabrication of said gate comprises the steps:
a) deposition over at least part of said semi-conducting structure, of at least one layer of precursor material (150) based on a compound of a mineral nature that comprises at least one metallic element and that is suitable to be broken down into at least one metallic material under the effect of an electron beam,
b) exposure of one or more zones of the layer of precursor material (150), to at least one electron beam (155, 255, 455), so as to form, on the semi-conducting structure (105, 205, 305, 405), one or more metallic zones (160, 260, 360), 460) based on said material, at the level of said zones exposed to the beam or beams.

4. A method for the fabrication of a microelectronic device according to claim 3, in which said compound is a fluoridated compound.

5. A method for the fabrication of a microelectronic device according to claim 4, in which said compound is chosen from among one of the following compounds - BaF₂, SrF₂, MgF₂, LaF₃, FeF₂, CrF₂, and AlF₃.

6. A method for the fabrication of a microelectronic device according to one of claims 1 to 5, in which, after exposure to said electron beam, also includes the removal of unexposed zones of the layer of precursor material (150).

7. A method for the fabrication of a microelectronic device according to one of claims 1 to 6, in which the structure is deposited on a substrate and comprises at least one cavity (221, 421a, 421b), or at least one opening, or at least one space between at least two of said semi-conducting bars (420c, 420b, 420a) and/or between at least one semi-conducting bar (220) and the substrate (200), with said deposition being achieved so as to fill in at least one zone of said cavity (221, 421a, 421b) or of said space or of said opening, by means of said precursor material (150).

8. A method for the fabrication of a microelectronic device according to claim 7, in which also includes the removal, at least partial, of the precursor material (150) in said filled-in zone.

9. A method for the fabrication of a microelectronic device with one or more transistors, in which includes the fabrication of at least one transistor gate (160, 260, 360, 460) on a semi-conducting structure (105, 205, 305, 405) that includes one or more bars (120a, 120b, 120c, 120d, 220, 320a, 320b, 320c, 420a, 420b, 420c) designed to play the role of one or more transistor channels, where the fabrication of said gate comprises the steps:
a) placement of the semi-conducting structure (105, 205, 305, 405) in a vapour of a precursor material suitable to be broken down into at least one metallic material under the effect of an electron beam,
b) localised exposure of one or more regions of said semi-conducting structure to at least one electron beam, so as to form one or more metallic zones (160, 260, 360, 460) based on said metallic material on said regions of said exposed semi-conducting structure to the beam.

10. A method for the fabrication of a microelectronic device according to claim 1 to 9, in which said structure (305) comprises a semi-conducting bar or several distinct semi-conducting bars (320a, 320b, 320c), resting on a substrate (300).

11. A method for the fabrication of a microelectronic device according to claims 1 to 10, in which said structure (105, 205) comprises at least one first semi-conducting block (110) and at least one second semi-conducting block (130) resting on a substrate, with one or more of said semi-conducting bars (120a, 120b, 120c, 120d, 220) connecting the first block (110) and the second block (130), and where said semi-conducting bars are suspended above the substrate (100, 200) and/or are not in contact with the substrate.

12. A method for the fabrication of a microelectronic device according to one of claims 1 to 11, in which said semi-conducting structure (105, 405) comprises at least two bars (120a, 120c, 120d, 420a, 420b, 420c) aligned in a direction that creates a non-zero angle with the main plane of the substrate (100, 400), and that are disconnected.

13. A method for the fabrication of a microelectronic device according to one of claims 1 to 12, in which the semi-conducting structure comprises at least aligned two bars (120b, 120d), 220a, 220b, 220c) in a direction parallel with a main plane of the substrate (120, 220), and that are disconnected.

14. A method for the fabrication of a microelectronic device according to claims 1 to 13, in which at least one of said metallic zones (160, 260, 360, 460) comprises at least two regions located in distinct planes.

15. A method for the fabrication of a microelectronic device according to claims 1 to 14, in which at least one of said metallic zones (160, 260, 360, 460) form a closed ring or band around at least one of said semi-conducting bars.

16. A method for the fabrication of a microelectronic device according to one of claims 1 to 15, comprises the deposition of at least one gate dielectric layer (140, 240, 340, 440) after formation of said structure and prior to stage a).
